Europäisches Patentamt

European Patent Office

Office européen des brevets

(11) Publication number: **0 210 578 B1**

(12) **EUROPEAN PATENT SPECIFICATION**

(45) Date of publication of patent specification: **20.05.92** (51) Int. Cl.⁵: **C23C 16/54**

(21) Application number: **86110049.3**

(22) Date of filing: **22.07.86**

(54) System and method for depositing an electrical insulator in a continuous process.

(30) Priority: **29.07.85 US 760305**

(43) Date of publication of application:
**04.02.87 Bulletin 87/06**

(45) Publication of the grant of the patent:
**20.05.92 Bulletin 92/21**

(84) Designated Contracting States:
**DE FR GB IT NL SE**

(56) References cited:
**EP-A- 101 286**
**EP-A- 0 041 773**
**EP-A- 0 046 059**
**EP-A- 0 076 426**
**US-A- 4 492 605**

(73) Proprietor: **ENERGY CONVERSION DEVICES, INC.**
**1675 West Maple Road**
**Troy Michigan 48084(US)**

(72) Inventor: **Cannella, Vincent D.**
**18625 Devonshire**
**Birmingham Michigan 48009(US)**

(74) Representative: **Müller, Hans-Jürgen, Dipl.-Ing. et al**
**Müller, Schupfner & Gauger Maximilian-strasse 6 Postfach 10 11 61**
**W-8000 München 1(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services
(3.08/2.19/2.0)

## Description

The invention concerns an apparatus and a method for depositing an electrical insulator over a substrate.

Apparatus and methods of the types mentioned in the opening parts of claims 1 and 5 are described in EP-A-0 076 426 and 0 101 286. Such apparatus and methods comprise at least one deposition chamber, at least another chamber adjacent said deposition chamber, coupling means between these at least two chambers for permitting said substrate to pass therethrough, transport means for transporting said substrate from one chamber into the other and isolating means for isolating the at least two chambers against contamination by including means for establishing unidirectional flow of a gas from one chamber into the other chamber. It is also known to use inert sweep gas and means for providing such gas adjacent the coupling means connecting the at least two chambers in order to prevent the contamination. These means are formed as gas gates of a particular construction wherein the gas enters through conduits which include apertures for directing the gas on both sides of the substrate.

The present invention is particularly useful in the manufacture of large area active matrices, such as liquid crystal displays of the type which employ a plurality of active electronic devices distributed throughout the matrix.

Amorphous silicon alloys have demonstrated a suitability for many electronic applications e.g. large area active matrices in liquid crystal displays. In such displays active elements such as thin film field effect transistors can be associated with each display pixel to provide isolation between the pixels and thus permit selective application of activating driving potentials to each pixel without the inadvertant activation of other pixels.

Thin film field effect transistors used for displays and other applications generally include source and drain electrodes, a semiconductor material, such as an amorphous silicon alloy, between the source and drain electrodes, and a gate electrode in proximity to the semiconductor but electrically insulated therefrom by a gate insulator formed from silicon oxide ($SiO_x$) or silicon nitride ($Si_xN_y$), for example. Current flow through the transistor between the source and drain is controlled by the application of a voltage to the gate electrode. The voltage on the gate electrode produces an electric field which accumulates a charged region near the semiconductor-gate insulator interface. This charged region forms a current conducting channel in the semiconductor through which the device current is conducted.

In order to achieve maximized field effect in such devices it is necessary that the gate insulator have a low defect density and a high resistivity. Thus, the gate insulator must be of high quality and as defect free as possible. Any defects, such as pinholes or the like, reduces the resistivity of the insulator and correpondingly reduces the strength of the field applied to the semiconductor per volt of gate voltage.

Thin film insulators are also required in other types of active liquid crystal displays. For example, in displays of the type which utilize diodes for isolating each display pixel from the other pixels. Alloy Diodes, insulating layers can be deposited for surrounding the diodes and to define vias through which interconnects and address lines can make electrical connection to the diodes. Insulators can also be used to form dielectric layers in thin film capacitors added to the display pixels. In addition to the foregoing, insulators can be utilized for encapsulating display subassemblies and for insulating crossing address lines when crossing address lines are required. In all of the aforementioned applications, the insulators must be of high quality and have low defect densitites, such as pinholes.

High quality and defect free electrical insulators are difficult to obtain when produced in thin film form from process gases because such processes are complex, utilizing both gas phase and surface reactions. Such deposited insulators are particularly difficult to form when required in association with devices including a semiconductor because the insulator forming process gases generally include elements which are well known to be deleterious in the formation of thin film semiconductors. For example, to form oxides, the process gases include oxygen, and to form nitride, the process gases include nitrogen. Both oxygen and nitrogen are well known to be deleterious in the formation of thin film semiconductors. Hence, in the past, when an insulator, such as an oxide, has been required in conjunction with thin film semiconductors, the oxide has been deposited by batch processing in a separate deposition chamber in order to isolate the semiconductor forming depositing environment from the insulator deposition gases. This unfortunately necessitates separate loading, unloading, and pump down of the separate chambers. Separate loading and unloading presents the possibility of contamination of the surface upon which the insulator is to be formed with water vapor, dust particles or other foreign matter. Such substances can create sites for pinholes and other defects in the deposited insulator which adversely effect its properties as an electrical insulator. Separate pump down requires that the deposition process be terminated at the end of each deposition and re-initiated at the start of each succeeding deposition. Practice has shown that such process interruptions adversely effect the quality of the deposited thin film and renders electrically insulating thin films less resistive due to resulting defects. Separate pump down also requires extra processing time which is a very important consideration in commercial applications.

In view of the foregoing, in order to produce thin films of high quality insulating material, processes other than batch processes would be desirable. A continuous process would be advantageous because it would not require process interruption and exposure to contamination of the surfaces to be deposited on. Furthermore, to produce active electronic circuits, such as active matrices of the type employing devices including field effect transistors for example, which include an insulator, continuous processing would be most desirable. Continuous processing is also advantageous since it lends itself to high volume mass production of such circuits over large substrate areas.

The problem of providing a continuous process system or method for depositing high quality insulating layers has apparently not been addressed by those in the art. Furthermore, the deposition of such insulating layers in conjunction with the deposition of high quality semiconductor layers adds further complications, which have apparently not been addressed by the art. One possible reason for this is that active devices include a semiconductor, and oxygen, which is a major component in insulating films such as silicon oxide and nitrogen, which is a major component in insulating films such as silicon nitride ($Si_xN_y$) are required in high concentrations in the process gases and are known to be very deleterious to the electrical properties of semiconductor material. As far as the applicant knows, those in the art have not devised a continuous processing system capable of depositing both a semiconductor and an electrical insulator, such as silicon oxide or silicon nitride, in one continuous process.

The present inventor and others affiliated with the assignee of the present invention had earlier developed systems, methods and devices for depositing amorphous silicon alloys in high volume continuous processing systems for photovoltaic uses. Systems of this kind are disclosed for example in US-A-4,400,409, 4,542,711 and 4,410,558. As disclosed in those patents, a substrate is continuously advanced through a succession of deposition chambers with each chamber being dedicated to the deposition of a specific type of material. In making a solar cell of PIN configuration, a first chamber is dedicated for depositing a p-type amorphous silicon alloy, a second chamber is dedicated for depositing an intrinsic amorphous silicon alloy, and a third chamber is dedicated for depositing an n-type amorphous silicon alloy. In order to make such a solar cell of maximum efficiency, each deposited alloy, and especially the intrinsic alloy, must be of high purity. As a result, it is necessary in such systems to isolate the deposition environment in the intrinsic deposition chamber from the doping constituents within the other chambers to prevent the diffusion of doping constituents into the intrinsic chamber. In the systems disclosed in the aforementioned patents, isolation between the chambers is accomplished with gas gates which pass an inert gas over the substrate as it passes from one chamber to the next.

An improvement to the systems disclosed in the above-mentioned patents is disclosed in US-A-4,438,723. In the continuous processing system disclosed in this patent, the deposition environment within the intrinsic amorphous silicon alloy deposition chamber is isolated from the deposition environments within the doped amorphous silicon alloy deposition chambers adjacent thereto by the maintenance of unidirectional gas flow from the intrinsic deposition chamber into the chambers adjacent thereto. As disclosed, it is preferred that the unidirectional gas flow be maintained through the gas gates through which the substrate is transported from one chamber to the next.

These references relating to the production of photovoltaic devices such as solar cells do not disclose how to adapt the systems or methods taught therein to deposit insulating layers such as silicon oxide or silicon nitride upon substrates.

It is an object of the present invention to provide such an apparatus and a method which allows a continuous process wherein the deposition needs not to be interrupted and wherein sufficient isolation is provided between the chambers so that contamination of other layers such as the intrinsic or doped semi-conductor layers does not result. The apparatus and method should allow mass production of substrates.

The invention is characterized in claims 1 and 5 and particular embodiments are claimed in subclaims and are described in the following specification and in the drawings.

Fig. 1 is a generally schematic side view of a continuous process system embodying the present invention;

Figs. 2 through 6 are cross-sectional side views of an intermediate subassembly for use in a liquid crystal display at various stages of its manufacture which preferably utilizes the method and system of the present invention, wherein

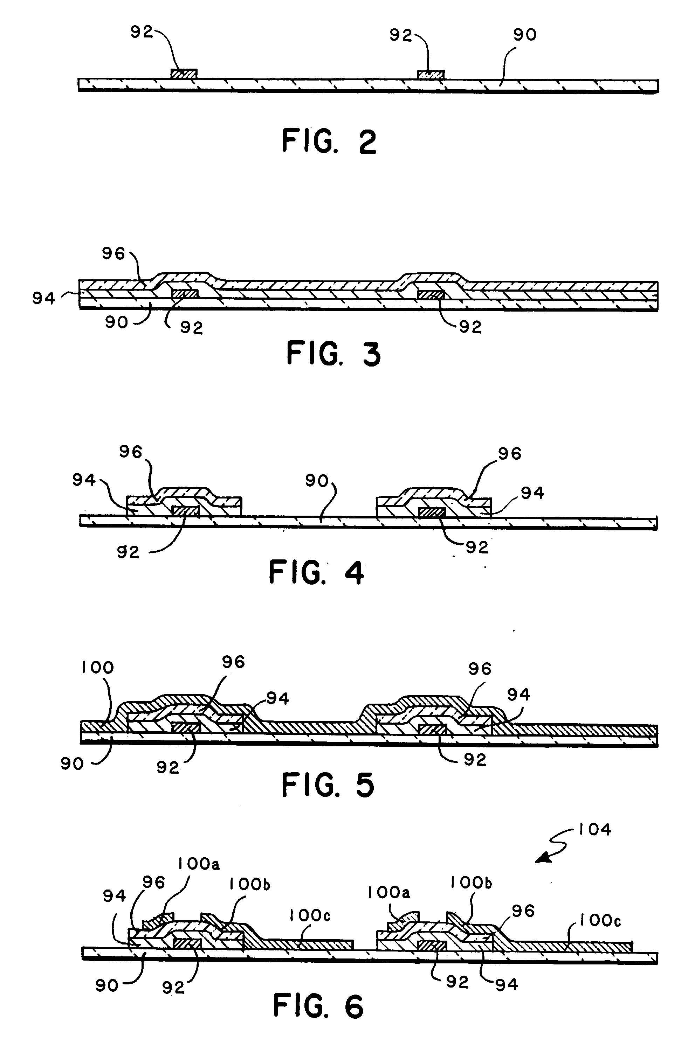

Fig. 2 illustrates a substrate having field effect transistor gate electrodes preformed thereon,

Fig. 3 illustrates the substrate after an insulator and an intrinsic semiconductor have been deposited thereon,

Fig. 4 illustrates the structure of Fig. 3 after a first patterning step,

Fig. 5 illustrates the structure of Fig. 4 after a transparent conductor has been deposited thereon, and

Fig. 6 illustrates the completed intermediate subassembly;

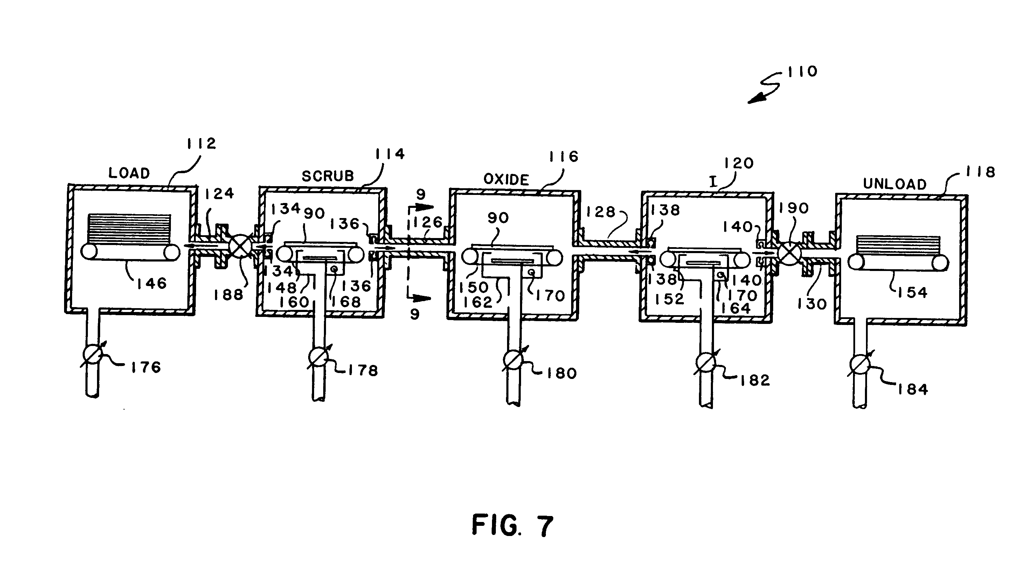

Fig. 7 is a generally schematic side view of another continuous processing system embodying the present invention which can be utilized to advantage in making the intermediate subassembly of Fig. 6.

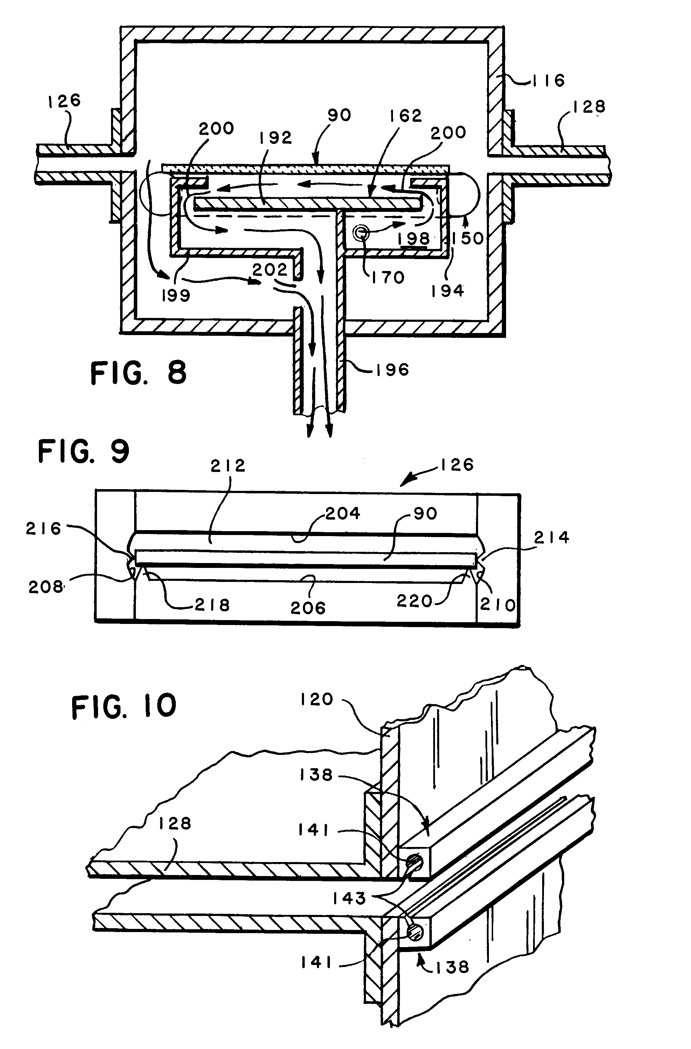

Fig. 8 is a side view of a deposition chamber of the system of Fig. 7 illustrating in greater detail the deposition gas flow arrangement within the chamber;

Fig. 9 is a cross-sectional view taken along lines 9-9 of Fig. 7;

Fig. 10 is a perspective view of a gas gate for coupling two of the deposition chambers of Fig. 7 together in accordance with the present invention;

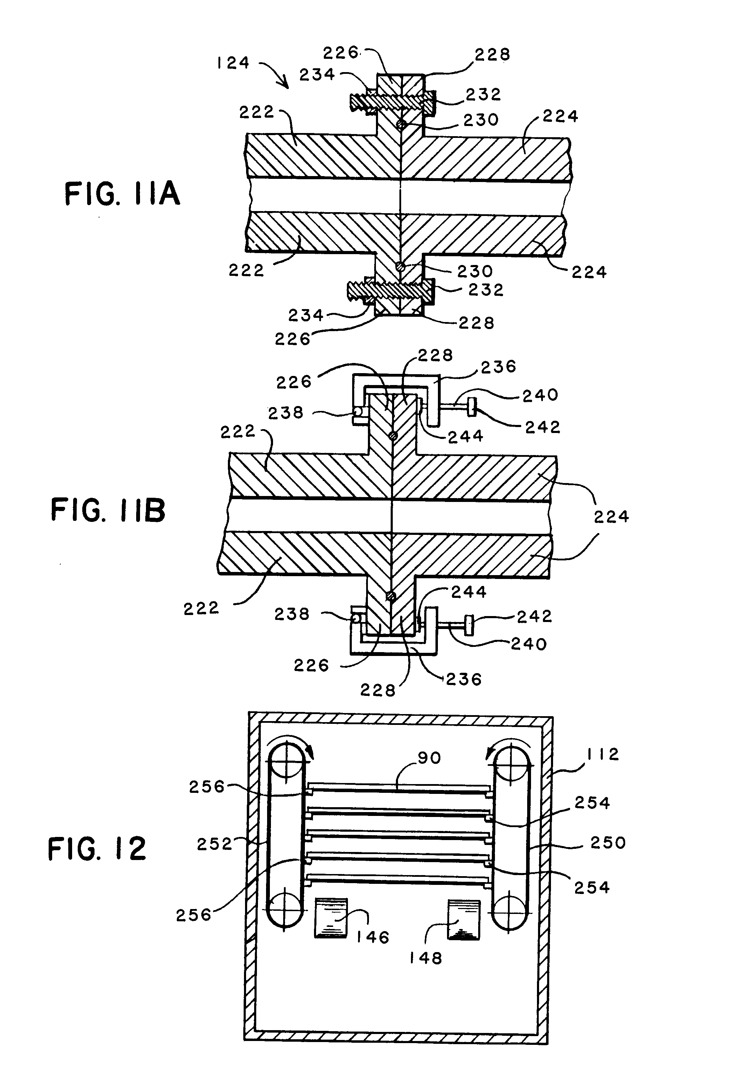

Figs. 11A and 11B are side views, partly in cross-section, illustrating alternative couplings for connecting the load and unload chambers to the rest of the system of Fig. 7;

Fig. 12 is a generally schematic end view of the load chamber of Fig. 7; and

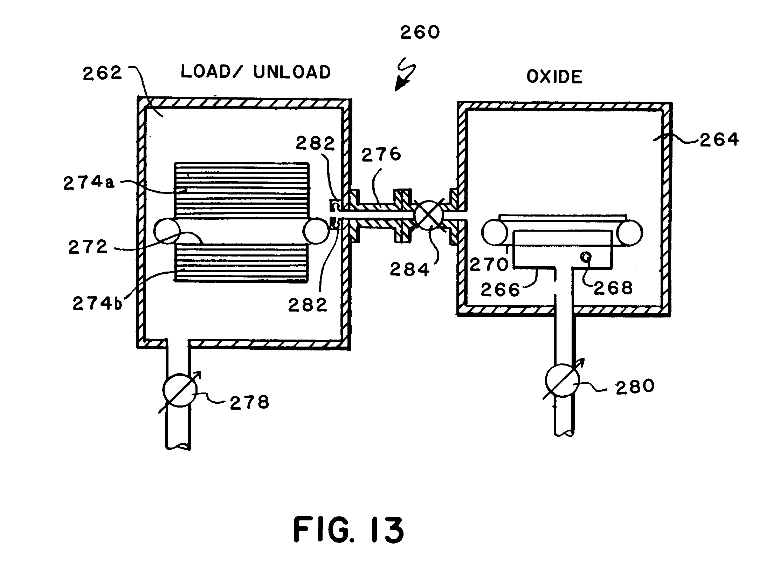

Fig. 13 is a generally schematic side view of another system embodying the present invention.

## DETAILED DESCRIPTION

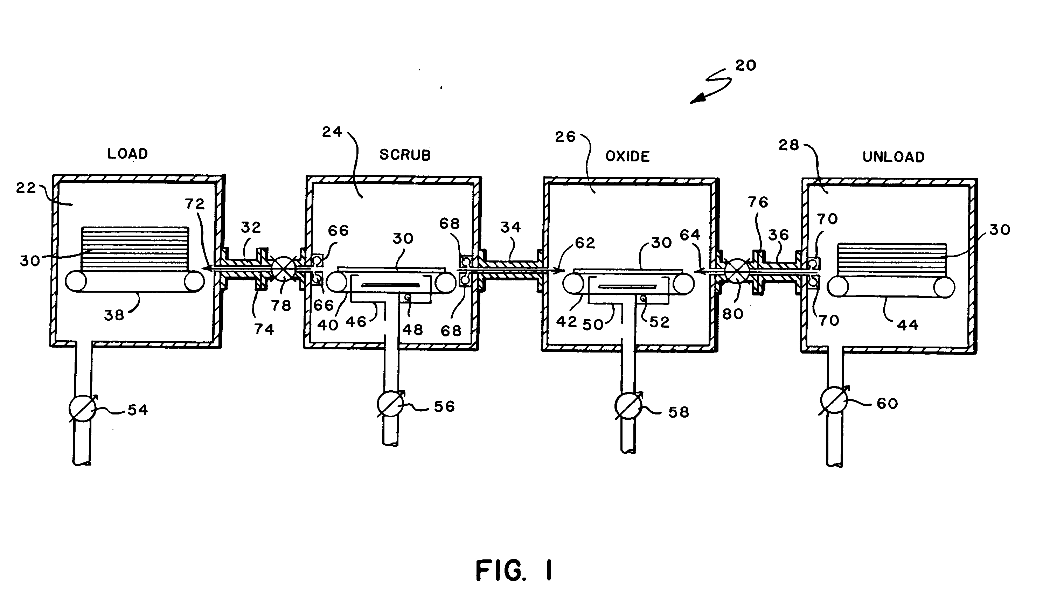

Referring now to Fig. 1, it illustrates a system 20 which embodies the present invention. The system 20 is adapted for depositing an electrical insulator, such as silicon oxide or silicon nitride over a plurality of substrates which are transported on a continuous basis through a plurality of processing chambers including an insulator deposition chamber. The system 20 generally includes a load chamber 22, a scrub chamber 24, an insulator or oxide deposition chamber 26, and an unload chamber 28. The load chamber 22 is adapted for storing a plurality of substrates 30 upon which the insulator is to be deposited. The scrub chamber 24 is adapted for cleaning the surface of the substrates upon which the insulator is to be deposited. The insulator deposition chamber 26 is adapted for depositing an electrical insulator, such as silicon oxide, over the substrate surface cleaned in the scrub chamber 24. Lastly, the unload chamber 28 is adapted for receiving the substrates 30 after the electrical insulator has been deposited thereon. If it is not necessary to clean the substrates, the scrub chamber 24 could be an idle chamber wherein no processing is performed to the substrates.

The chambers 22, 24, 26, and 28 are coupled together in a series arrangement by a plurality of coupling means which include a gas gate 32 which couples the load chamber 22 to the scrub chamber 24, a gas gate 34 which couples the scrub chamber 24 to the insulator deposition chamber 26, and a gas gate 36 which couples the insulator deposition chamber 26 to the unload chamber 28. Each of the gas gates 32, 34, and 36 is dimensioned to permit the substrates 30 to pass therethrough as they are transported from one chamber to the next in succession. As will be described more completely hereinafter, the gas gates 32, 34, and 36 are also dimensioned for conducting gas flow therethrough to provide effective isolation between the chambers of the system.

Each of the chambers 22, 24, 26, and 28 include conveyor means in the form of endless belt conveyors 38, 40, 42, and 44 respectively. The conveyors are dimensioned with respect to the dimensions of the substrates 30 and the length of the gas gates 32, 34, and 36 so that before a conveyor releases a substrate it is transporting, the next conveyor is able to grip and support the substrate being transported. Preferably, each endless conveyor includes a pair of belts which are spaced apart so as to contact only opposing side margins of the substrate to enable essentially the entire surface area of the substrate to be exposed for processing.

The transport means of the system 20 is particularly suited for transporting substrates which are formed from a rigid material such a glass. However, flexible substrates can also be transported if they are mounted in a suitable rigid carrier which provides the support for the substrates at their peripheral margins. In this case, the belts of the endless conveyors will contact opposing side margins of the carriers.

The scrub chamber 24 and insulator deposition chamber 26 each include means for forming a glow discharge plasma from a process gas or gases. To that end, the scrub chamber 24 includes a cathode assembly 46 and a gas inlet 48. The insulator deposition chamber 26 includes a cathode assembly 50 and a gas inlet 52. To form the glow discharge plasmas, the cathode assemblies 46 and 50 are coupled to a source of RF energy (not shown) such as an RF transmitter having an output frequency of 13.58 megahertz, for example. The scrub chamber 24 cleans the bottom surface of the substrates 30 by utilizing a glow discharge plasma formed from an appropriate gas, such as argon gas, which is fed to the cathode assembly 46 through the gas inlet 48. The insulator deposition chamber 26 deposits an electrical insulator, such as silicon oxide, onto the surface of the substrate 30 which has been cleaned in the scrub chamber 24. The insulator is deposited by a glow discharge plasma formed from process gases including, for example, silane (SiH$_4$) and nitrous oxide (N$_2$O) which are fed to the cathode assembly 50 through the gas inlet 52.

During the operation of the system 20, the interior of each of the chambers 22, 24, 26, and 28 is maintained at a partial vacuum pressure such that the entire system is a closed system. To that end, the system 20 includes pressure control means including an absolute pressure control pump 54, 56, 58, and 60 associated with each of the chambers 22, 24, 26, and 28 respectively. The absolute pressure control pumps maintain a pressure within the chambers at about 133 Pa to enable the establishment of the glow discharge plasmas within the scrub chamber 24 and the insulator deposition chamber 26. In accordance with the present invention, the absolute pressure control pump 58 maintains a pressure within the insulator deposition chamber 26 which is slightly lower than the pressures maintained within the scrub chamber 24 and the unload chamber 28 by the absolute pressure control pumps 56 and 60 respectively. This maintains a unidirectional gas flow from the scrub chamber 24 and the unload chamber 28 into the insulator deposition chamber 26 as indicated by the arrows 62 and 64. The unidirectional gas flow into the insulator deposition chamber 26 serves to isolate the oxide forming constituent elements within the chamber 26 from the interior of the scrub chamber 24 and the unload chamber 28. As previously mentioned, the oxygen required to form the silicon oxide insulator within the deposition chamber 26 can cause contamination within the other chambers. Unidirectional gas flow into the insulator deposition chamber 26 as indicated by the arrows 62 and 64 form a barrier to diffusion of the oxygen constituents within the chamber 26 to provide the necessary isolation.

Also during the operation of the system 20, an inert gas is swept through the gas gates 32, 34, and 36. To accomplish this, gas conduits 66, 68, and 70 are provided. The inert gas can be, for example, argon gas. As can be noted from Fig. 1, the gas conduits 68 and 70 cause the inert gas to be swept through the gas gates 34 and 36 in the direction of the unidirectional gas flow as indicated by the arrows 62 and 64. Also, the conduits are provided on opposite sides of the gas gates so that the inert gas is swept across both the top and bottom surfaces of the substrates as they pass through these gas gates. The conduits 66 cause the inert gas to be swept through the gas gate 32 from the scrub chamber 24 to the load chamber 22 as indicated by the arrow 72.

In order to optimize the efficiency of the system 20, the load chamber 22 and unload chamber 28 are detachable from the system at the flanges 74 and 76. As a result, when all of the substrates 30 within the load chamber 22 have been transferred to the scrub chamber 24, a valve 78 can be closed to enable the load chamber 22 to be disconnected from the scrub chamber 24 without necessitating exposing the scrub chamber 24 to ambient pressure. A similar load chamber having substrates stored therein can then be connected to the scrub chamber 24 and then pumped down to the appropriate pressure to enable the valve 78 to once again be opened and to initiate a new run of substrates through the system.

Similarly, when the unload chamber 28 has been filled with substrates to its capacity, another valve 80 can be closed to facilitate the removal of the unload chamber 28 from the insulator deposition chamber 26 and an empty unload chamber to be connected to the insulator deposition chamber 26. Once the new unload chamber has been pumped down to the appropriate pressure, the valve 80 can once again be opened to initiate the deposition process. This can be accomplished without necessitating the interruption of the glow discharge plasma within the insulator deposition chamber 26.

In operating the system 20 of Fig. 1, a load chamber 22 which is fully loaded with substrates 30 is connected to the scrub chamber 24. Similarly, an empty unload chamber 28 is connected to the insulator deposition chamber 26. The valves 78 and 80 are open and each of the chambers 22, 24, 26, and 28 is pumped down by the pumps 54, 56, 58, and 60 respectively to an appropriate partial vacuum pressure. In operation, the following parameters and process steps could be utilized, for example, while depositing silicon oxide in the insulator deposition chamber 26. The load chamber can be pumped down to a pressure of about 127 Pa the scrub chamber can be pumped down to a pressure of about 133 Pa, the insulator deposition chamber 26 can be pumped down to a pressure of about 127 Pa, and the unload chamber 28 can be pumped down to a pressure of about 133 Pa. The scrub chamber 24 and insulator deposition chamber 26 are then caused to initiate their RF glow discharge plasmas. In the scrub chamber 24, the gas inlet 48 of the cathode assembly 46 provides argon gas at a flow rate of 500 SCCM, substrate heaters (not shown) within the interior of the chamber are energized for heating the substrates to a temperature of about 300°C, and RF power is applied to the cathode assembly at a power of about 0,1 W/cm$^2$ of the substrate area. The insulator deposition chamber 26 receives at its gas inlet 52 of the cathode assembly 50 a mixture of 5% silane gas with 95% helium gas at a flow rate of 300 SCCM, nitrous oxide gas at a flow rate of 600 SCCM, and argon gas at a flow rate of 300 SCCM. Substrate heaters (not shown) within the insulator deposition chamber 26 are energized to heat the substrate to about 350°C and RF power of about 0,1 W/cm$^2$ of substrate area is applied to the cathode assembly 50. Lastly, the pressure differential between the deposition chamber and the adjoining chambers is adjusted to provide a flow rate through the gas gates corresponding to the degree of isolation desired between the chambers. Then, the gas conduits 66, 68, and 70 are provided with argon gas at a flow rate corresponding to the desired flow rate through the gas gates. For example, for gas gates dimensioned as described hereinafter, if the sweep gas flow rate from the gas conduits is 200 SCCM, the ratio of the concentration of the elemental constituents within the insulator deposition chamber 26 to the concentration of those elements within the scrub chamber 24 and unload chamber 28 immediately adjacent thereto will be on the order of 10$^2$. If the sweep gas flow rate is 800 SCCM, for example, the above noted concentration ratio will be 10$^6$. A concentration ratio of 10$^5$ can be obtained at a sweep gas flow rate of 650 SCCM.

In practice, the degree of isolation desired will largely depend upon the particular application. For example, when an insulator is deposited in a system such as of the type shown in Fig. 1 wherein a semiconductor is not deposited, the required degree of isolation can be less than the required degreee of isolation wherein a semiconductor is also deposited, such as in a system of the type shown in Fig. 7. For example, in an application of the type shown in Fig. 1, a concentration ratio of at least 10$^2$ can be entirely satisfactory whereas, in an application of the type shown in Fig. 7 to be described subsequently, a concentration ratio of 10$^5$ can be required.

The degree of isolation between the insulator deposition chamber and the immediately adjacent preceding and succeeding chambers is dependent upon the sweep gas flow rate, the length of the gas gates, the cross-sectional area of the gas gates, the pressure within the gas gates, and the diffusion coefficient which is the measure of how fast one gas moves through another gas at a certain pressure and temperature. However, the sweep gas flow rate, the pressure within the gas gates, and the gas gate dimensions are all interdependent. Hence, the best way of relating these parameters to the degree of isolation expected is through a gas gate constant G which takes all of these parameters into account. The gas gate constant G can be expressed as below.

$$G = \sqrt{\frac{MF \times L}{D \times P \times A}}$$

where:

MF is the sweep gas flow rate (mass flow rate) in 10$^5$ Pa·cm$^3$/s.
L is the gas gate length in centimeters;
A is the gas gate cross-sectional area in square centimeters;
P is the average gas gate pressure in 10$^5$·Pa; and
D is the diffusion coefficient in cm$^2$/s.

It has been determined that if G is above 1.8 an isolation concentration ratio of greater than 10$^2$ can be obtained. If G is above 3.3 an isolation concentration ratio of greater than 10$^5$ can be obtained. As previously mentioned, in applications wherein a semiconductor is also deposited, a concentration ratio of 10$^5$ or greater may be required to provide adequate isolation from adjoining chambers because of the high concentration of the insulator forming gases present within the insulator deposition chamber for depositing a high quality insulator. For most applications, if the value of G is between 2 and 4, sufficient isolation can be obtained while affording both reasonable gas gate dimensions and chamber pressures for sustaining a glow discharge deposition environment within the insulator deposition chamber.

Once the glow discharge plasma environments are established in the scrub chamber 24 and the insulator deposition chamber 26, the conveyor 38 is energized to commence the one-by-one feeding of the substrates 30 through the gas gate 32 and into the scrub chamber 24. The substrates 30 are fed through the chambers from the load chamber 22 to the unload chamber 28 in succession. When the load chamber 22 is empty of substrates and the unload chamber 28 is fully filled with substrates, the load and unload chambers are disconnected from the system after the valves 78 and 80 are closed to facilitate the connection of new load and unload chambers to the system. Once the new load and unload chambers are pumped down to the appropriate pressures, the valves 78 and 80 are once again opened and the process is reinitiated.

If it is desired to deposit a silicon nitride (Si$_x$N$_y$) insulating layer, the deposition parameters within chamber 26 can be, for example, a substrate temperature of 200°C, a pressure of about 53 Pa and a process of 0,03 W/cm$^2$. Ammonia gas (NH$_3$) at a flow rate of 300 SCCM and silane (SiH$_4$) at a flow rate of 50 SCCM can be fed to the chamber 26. The adjacent chambers can be maintained at a pressure of about 7 Pa above the pressure within chamber 26, or about 60 Pa. The sweep gas flow rates previously mentioned can also be used.

As can be seen from the foregoing, the system 20 of Fig. 1 provides for the deposition of an insulator over the substrates in a continuous process. In addition, the deposition environment within the insulator deposition chamber 26 need not be interrupted to assure the deposition of a high quality, defect free, insulator over the substrates.

Figs. 2 through 6 illustrate an intermediate subassembly for a liquid crystal display at various stages of its manufacture which can be made utilizing the system and method of the present invention as shown in Fig. 7. More specifically, the system and method of the present invention can be utilized to form a plurality of layers of various materials over a substrate wherein the plurality of layers include at least an electrically insulating layer and an intrinsic amorphous silicon alloy layer as shown in Fig. 3.

Referring now to Fig. 2, it illustrates a substrate 90 formed from an electrical insulator such as glass, having a plurality of electrodes 92 formed thereon. The electrodes 92, which will eventually become the gate electrodes for a corresponding plurality of thin film field effect transistors, can be formed from metal, such as chromium, and can be deposited and patterned in a conventional manner.

The substrate 90 with the electrodes 92 thereon is then processed in accordance with the system and method of the present invention. As a result, formed over the substrate as shown in Fig. 3 are a layer 94 of electrically insulating material, such as silicon oxide ($SiO_x$), and a layer 96 of an intrinsic amorphous silicon alloy. Other layers could also be formed such as a layer of doped n-type amorphous silicon alloy. In accorance with the present invention, the layers 94 and 96 can be deposited in one continuous process wherein the substrate 90 is transported through a plurality of processing chambers in succession. The chambers form a closed system wherein a partial vacuum is maintained in each chamber to preclude exposure of the substrate 90 to the external environment between depositions and gas flow is maintained between the chambers as described subsequently to isolate the insulator deposition chamber from the rest of the system.

After the layers 94 and 96 are deposited over the substrate 90, the substrate with the layers 94 and 96 thereon are removed from the system and the layers are patterned to form the structure illustrated in Fig. 4. The layers 94 and 96 can be patterned by a conventional photolithography process wherein the top most layer 96 is coated with a photoresist. The photoresist is then exposed through a mask and then developed. After the developing step, the layers 94 and 96 are exposed to a suitable etchant to form isolated islands of the layers 94 and 96 as illustrated in Fig. 4.

A layer 100 of transparent conductive material is next deposited over the structure of Fig. 4 as shown in Fig. 5. The layer 100 of transparent conductive material can be formed from indium tin oxide, for example.

To complete the intermediate subassembly, the layer 100 of transparent conductive material is patterned to form drain and source electrodes for each field effect transistor, and a pixel electrode for each pixel. As shown in Fig. 6, after the layer 100 of transparent conductive material is patterned, each field effect transistor includes a gate electrode 92, a gate insulator 94, an intrinsic amorphous silicon alloy 96, a drain electrode 100a, a source electrode 100b, and a pixel electrode 100c coupled to the source electrode 100b. As a result, an intermediate subassembly 104 is formed which can be used in the manufacture of a liquid crystal display.

Referring now to Fig. 7, it illustrates a continuous process system 110 embodying the present invention which can be utilized in the process of making the intermediate subassembly 104 of Fig. 6. More specifically, the system 110 is arranged for producing the partially completed intermediate subassembly as illustrated in Fig. 3. To that end, the system 110 includes means for depositing the electrical insulator layer 94 and the intrinsic amorphous silicon alloy layer 96 over the substrate 90.

Like the system 20 of Fig. 1, the system 110 includes a load chamber 112, a substrate cleaning chamber 114, an insulator deposition chamber 116, and an unload chamber 118. Each of these chambers performs the same functions as the corresponding chambers previously described with respect to the system 20 of Fig. 1. In addition, the system 110 includes an intrinsic semiconductor deposition chamber 120. The intrinsic semiconductor deposition chamber 120 is arranged for depositing over the insulator deposited onto the substrates within chamber 116 an intrinsic amorphous silicon alloy.

The system 110 further includes a plurality of gas gates 124, 126, 128, and 130 for coupling the chambers together in a series arrangement. The gas gates provide the same function as the gas gates 32, 34, and 36 previously described with respect to the system 20 of Fig. 1. Associated with the gas gates are a plurality of sweep gas feed means 134, 136, 138, and 140 which feed an inert sweep gas, such as argon gas, in the direction of the gas flow through the gas gates, on opposite sides of the substrates as they pass therethrough.

Like the gas gates of the system 20 of Fig. 1, the gas gates 124, 126, 128, and 130 of the system 110 are dimensioned to permit the substrates to pass therethrough as the substrates are transported from one chamber to the next in succession. For transporting the substrates, each of the chambers 112, 114, 116, 120, and 118 includes an endless belt conveyor 146, 148, 150, 152, and 154. In practice, each such conveyor can include two endless belt conveyors which are spaced apart and substantially parallel to one another for contacting opposing peripheral side margins of the substrates.

In order to perform the substrate cleaning and the deposition processes, the system 110 further includes cathode assemblies 160, 162, and 164 within the chambers 114, 116, and 120 respectively. The cathode assemblies are disposed between the pair of corresponding endless conveyor belts within the chambers 114, 116, and 120 so that they do not interfere with the transportation of the substrates through the chambers. The cathode assemblies are also positioned with respect to the substrate surfaces for forming a plasma closely adjacent to the substrate surfaces. To facilitate the formation of a glow discharge plasma by the cathode assemblies, the cathode assemblies include gas inlets 168, 170, and 172. The gas mixtures received by the cathode assemblies through the gas inlets will be described subsequently.

To further facilitate the formation of a glow discharge plasma within the chambers 114, 116, and 120 the cathode assemblies 160, 162, and 164 are coupled to a source of RF energy (not shown) in a manner well known in the art. The RF energy sources are not shown in Fig. 7 so as to not unduly complicate the figure. The RF sources can be, for example, RF transmitters having an output frequency of 13.58 megahertz for example.

During the operation of the system 110, the system is a closed system wherein each of the chambers 112, 114, 116, 120, and 118 is pumped down to a partial vacuum pressure. To that end, each of the chambers is associated with an absolute pressure control pump 176, 178, 180, 182, and 184 which comprise pressure control means for the system 110.

Lastly, to complete the system 110, the system includes a valve 188 associated with the substrate cleaning chamber 114 and valve 190 associated with the intrinsic semiconductor deposition chamber 120. The valves 188 and 190, when closed, permit the removal of the load chamber 112 and the unload chamber 118 from the system without losing the vacuum within or contaminating the rest of the system.

One of the cathode assemblies, for example cathode assembly 162 of the insulator deposition chamber 116 is shown in greater detail in Fig. 8.

One of the conveyor belts is partially shown in Fig. 8 along with a substrate 90 so as to make it easier to understand the operation of the cathode assembly 160.

The cathode assembly 162 includes the gas inlet 170 through which process gates for the cathode assembly are received and a cathode 192 which is adapted for connection to an RF energy source (not shown). The cathode assembly 162 further includes a wall 194 which defines along with a gas conduit 196 a gas mixing chamber 198. On the side of the conduit 196 opposite the wall 194 is another wall 199 which serves to direct the unused process gases into the conduit 196 to thereafter be pumped from the system by the pump 180 shown in Fig. 7. The process gas flow around the cathode 192 is indicated by the arrows 200. An opening 202 within the conduit 196 permits the interior of the chamber 116 to be pumped down to a suitable partial vacuum pressure by the pump by virtue of the spacing between the wall of the chamber 116 and the walls 194 and 199 of the cathode assembly 162.

Referring now to Fig. 9, it illustrates a cross section of the gas gate 126 of Fig. 7 taken along lines 9-9. As can be seen from the figure, the gas gate 126 includes substantially planar side walls 204 and 206, and a pair of generally arcuate side walls 208 and 210 which define a generally rectangular opening 212. The walls 206, 208, and 210 include guide projections 214, 216, 218, and 220. The guides serve to support and guide the substrate 90 as it passes through the rectangular opening 212. The guides 218 and 220 preferably contact the substrate 90 along its side margins outside of the substrate portion to be deposited on and are of particular importance because they separate the substrate 90 from the bottom wall 206 of the gas gate 126 to permit the sweep gas to flow along the bottom side of the substrate 90. The rectangular opening 212 and the guides are dimensioned to permit the substrate 90 to pass through the gas gate 126 in a guided manner. The inner dimensions of the rectangular opening 212 as an example can be 40 cm wide, 25 cm long, and 0,6 cm high. Of importance are the length and height dimension of the rectangular opening 212. The isolation concentration ratios provided by the unidirectional gas flow described with respect to the exemplary operation of the Fig. 1 system relates to a gas gate having these inner dimensions.

Fig. 10 illustrates in greater detail one of the gas gates, for example, gas gate 128 in association with the sweep gas feed means 138. As can be seen in the figure, the sweep gas feed means 138 comprises a pair of conduits 141 which extend along the entire width of the gas gate 128 transverses to the direction of the unidirectional gas flow.

The conduits 141 communicate with the gas gate through inlet slits 143 which in turn extend along the entire length of the conduits 141. As a result, the sweep gas is caused to be fed by the sweep gas feed means 138 across the entire surface area of the substrate along the major opposing surfaces thereof as the substrate is transported through the gas gate 128.

Referring now to Figs. 11A and 11B, they illustrate alternate ways in which the load chamber 112 and unload chamber 118 can be connected and disconnected from the system 110. For purposes of this discussion, it is assumed that the gas gate thereshown is the gas gate 124 extending between the load chamber 112 and the scrub chamber 114.

As can be seen in the figures, the gas gate 124 includes two portions 222 and 224 with portion 222 being carried by the load chamber 112 and the portion 224 being carried by the scrub chamber 114. Each of the portions 222 and 224 includes a flange 226 and 228 respectively. The flanges 226 and 228 preferably extend around the entire periphery of the portions 222 and 224. A sealing o-ring 230 is provided between the flanges when the portions 222 and 224 are brought together.

Figs. 11A and 11B illustrate two different alternatives for fixing the flanges together. The first alternative in Fig. 11A includes a plurality of bolts, one such bolt 232 being shown, extending through aligned apertures of the flanges and a nut 234 threadingly engaging the bolt 232. The other alternative in Fig. 11B includes a u-shaped member 236 which is hingedly coupled to the flange 226 at a hinge 238. At the end of the u-shaped member 236 opposite the hinge 238 is a threaded member 240 having a knob shaped member 242 at one end and an engagement member 244 at the other end. The member 240 is threaded intermediate its ends and mates with a threaded bore within the u-shaped member such that the u-shaped member 236 can be swung to the position illustrated and the knob 242 turned so that the engagement member 244 securely engages the flange 238. With the member 240 tightened, the flanges will be securely held together. Of course, a plurality of such u-shaped members 236 are required. When it is desired to separate the portions 222 and 224, the knob 242 is turned in the opposite direction to loosen the member 240 and disengage the engagement member 244 from the flange 228. The u-shaped member 236 can then be swung out of the way about the hinge 238 to permit the portions 222 and 224 to be separated.

Fig. 12 is an end view of the load chamber 112 illustrating the major component parts therein. As can be seen in the figure, the load chamber includes a pair of conveyors 250 and 252 which carry a plurality of stops 254 and 256 respectively.

Supported on opposing stops and extending across the chamber are a plurality of substrates 90 to be processed. The chamber 112 also includes an endless conveyor with a pair of belts 146 and 148. When the system 110 is in operation, the conveyor belts 250 and 252 lower the stops 254 and 256 in unison such that one of the substrates 90 is placed upon the conveyor belts 146 and 148. The conveyors 250 and 252 can be moved continuosly at a slow rate such that the next substrate is placed onto the conveyor belts 146 and 148 immediately after the preceding substrate has passed from the load chamber 112 through the gas gate 124 into the scrub chamber 114 or the belts 240 and 252 can be moved incrementally.

Referring once again to Fig. 7, when the system 110 is in operation, the pumps 176, 178, 180, 182, and 184 establish partial vacuums within each of the chambers. For example, the pumps can establish pressures of about 127 Pa in load chamber 112, about 133 Pa in scrub chamber 114, about 127 Pa in the insulator deposition chamber 116, about 133 Pa in the intrinsic semiconductor deposition chamber 120, and about 127 Pa in the unload chamber 118. These pressures assure unidirectional flow of gas from the scrub chamber 114 and the intrinsic semiconductor deposition chamber 120 into the insulator deposition chamber 116 through the gas gates 126 and 128. Also, the inert sweep gas is also caused to be swept through the gas gates 126 and 128 in the direction of the unidirectional gas flow. The pressure differentials and the sweep gas flow assure that the insulator deposition chamber 116 is effectively isolated from the other chambers of the system to assure that no deleterious amounts of the oxygen deposition constituents within the insulator deposition chamber 116 diffuse into the chambers adjacent the chamber 116.

For forming the structure illustrated in Fig. 3, the system is operated such that argon gas is delivered to the gas inlet 168, a 5% mixture of silane with helium is delivered to the cathode inlet 170 at a flow rate of 300 SCCM with nitrous oxide at a flow rate of 600 SCCM, and silane gas is delivered to the cathode gas inlet 172 at a flow rate of 100 SCCM with helium gas at a flow rate of 500 SCCM. Each of the cathode assemblies 160, 162, and 164 can be provided with RF power of about 0,1 W/cm$^2$ of substrate area. Substrate heaters (not shown) within the chambers are energized for heating the substrate within the scrub chamber 114 to 300°C, the insulator deposition chamber 116 to 350°C, and the intrinsic semiconductor deposition chamber 120 to 250°C. Also, the sweep gas can be provided to the gas gates at a flow rate of 650 SCCM to obtain an isolation concentration ratio of $10^5$, or 800 SCCM to obtain an isolation concentration ratio of $10^6$ as previously referred to.

In producing the structure illusrated in Fig. 3 with the system of Fig. 7, the substrates 90 having the gate electrodes 92 formed thereon are provided to the load chamber 112. Each of the chambers is pumped down to its appropriate pressure and the glow discharge environments are initiated in each of the chambers having a cathode assembly as previously described. The substrates are then placed one at a time onto the conveyor 146 and transported from the load chamber 112 into the scrub chamber 114 and then serially in succession through the remaining chambers to the unload chamber 118. In this manner, a plurality of substrates can be processed in the closed environment of the system 110 without being exposed to ambient conditions. This assures that a high quality insulator, such as silicon oxide, is deposited onto the substrates, while the unidirectional flow of gas from the scrub chamber 114 and the intrinsic semiconductor deposition chamber 120 into the insulator deposition chamber 116 assures that the other chambers are not contaminated with the oxygen deposition species created within the insulator deposition chamber 116.

Referring now to Fig. 13, it illustrates another system 260 embodying the present invention. The system 260 comprises a first chamber 262 and a second chamber 264. Chamber 262 comprises a load/unload chamber for storing both unprocessed and processed substrates. Chamber 264 comprises an insulator deposition chamber for depositing an insulator such as silicon oxide ($S_iO_x$) over the substrates.

Chamber 264 is essentially identical to the insulator deposition chambers previously described. It includes a cathode assembly 266 for forming a glow discharge plasma from process gases fed from a gas inlet 268. The chamber 264 further includes an endless conveyor 270. Unlike the conveyors previously described, the conveyor 270 is arranged for both receiving the unprocessed substrates from the chamber 262 and for transporting the substrates, after being processed, back to the chamber 262.

The load/unload chamber 262 includes an endless conveyor 272. The conveyor 272 is arranged for transporting the unprocessed substrates 274a disposed above the conveyor to the insulator deposition chamber 264. The conveyor is further arranged to receive the processed substrates from the chamber 264 so that the process substrates 274b can be stored below the conveyor 272. After a substrate has been processed in chamber 264, the conveyors 270 and 272 can be energized to operate in a reverse direction for transporting the processed substrate back to chamber 262. Thereafter, the substrate can be held in a temporary stationary position until the belts of conveyor 272 have been moved laterally by a sufficient distance so as to be clear of the side margins of the substrate. The processed substrate can then be lowered to a position below the conveyor for storage.

Like the systems previously described, the chamber 262 communicates with chamber 264 through a coupling means or gas gate 276. The gas gate 276 is dimensioned as previously described to permit the substrates to pass therethrough and to conduct unidirectional gas flow from the chamber 262 to the chamber 264 to provide adequate isolation between the chambers.

To maintain the unidirectional gas flow through the gas gate 276, the system includes absolute pressure control pumps 278 and 280. The pumps 278 and 280 maintain the internal pressure of chamber 264 below the internal pressure of chamber 262. Also, sweep gas feed means 282, of the type previously described, provides a flow of an inert sweep gas, such as argon, through the gas gate in the direction of the unidirectional gas flow.

A valve 284 is associated with the chamber 264 in the gas gate 276. The valve 284, as previously described, permits the chamber 262 to be separated from chamber 264 after all of the substrates have been processed and to permit another load/unload chamber having unprocessed substrates therein to be connected to the chamber 264 without requiring interruption of the partial vacuum within the chamber 264.

The system 260 can be operated by using the same exemplary parameters described with respect to the operation of the systems of Figs. 1 and 7. For example, the pressure within chamber 264 can be maintained at about 127 Pa, the pressure within chamber 262 can be maintained at about 133 Pa, and the sweep gas feed rate can be 200 SCCM. The oxide deposition including the process gas mixtures and flow rates and the substrate parameter temperature can be the same as described with respect to the oxide deposition chamber 116 of Fig. 7.

From the foregoing, it can be seen that the present invention provides a new and improved system and method for depositing an electrical insulator over a substrate. The present invention provides such a system and method which is a continuous process wherein the deposition processes need not be interrupted, and wherein sufficient isolation is provided between the chambers so that contamination of other layers, such as the intrinsic or doped semiconductor layers, does not result. The system and method of the present invention also lends itself to mass production of substrates, and particularly to the making of an intermediate subassembly for a liquid crystal display or to other circuit arrays of the type incorporating active or passive circuit devices which require a layer of an electrical insulator.

**Claims**

1. Apparatus for depositing an electrical insulator over a substrate (30, 90, 274a), comprising:
   an insulator deposition chamber (26; 116; 264) for depositing said insulator over said substrate;
   at least a first additional chamber (24; 114; 262) adjacent said insulator deposition chamber;
   first coupling means (34; 126; 276) arranged between said insulator deposition chamber and said first additional chamber for permitting said substrate to pass therethrough;
   first transport means (40; 148; 272) for transporting said substrate from said first additional chamber to said insulator deposition chamber;
   first means (56, 58; 178, 180; 278, 280) for maintaining unidirectional gas flow through said first coupling means from said first additional chamber into said insulator depositing chamber; and
   sweep gas feed means (68; 136; 282) disposed adjacent said first coupling means for feeding an inert sweep gas into said coupling means in the direction of said unidirectional gas flow,
   **characterized in that**
   said each of said sweep gas feed means (68; 136; 282) extends along the entire width of its respective coupling means (34; 126; 276) transverse to the direction of said unidirectional gas flow through said coupling means and that said sweep gas feed means (68; 136; 282) are disposed on opposite sides of said first coupling means (34; 126; 276).

2. Apparatus as claimed in claim 1,
   **characterized in that**
   said means (56; 58; 178; 180; 278; 280) for maintaining unidirectional gas flow include pressure control means for maintaining said insulator deposition chamber (26; 116; 264) at a lower internal pressure than the internal pressure of said first additional chamber (24; 114; 262).

3. Apparatus as claimed in claim 1 or 2,
   **characterized by**
   a second additional chamber (28; 120) adjacent said insulator deposition chamber (26; 116; 264);

   second coupling means (36; 128) arranged between said insulator deposition chamber and said second additional chamber for permitting said substrate (30; 90; 274a) to pass therethrough;
   second transport means (42; 150) for transporting said substrate from said insulator deposition chamber to said second additional chamber; and
   second means (60; 182) for maintaining unidirectional gas flow through said second coupling means from said second additional chamber (28; 120) into said insulator deposition chamber (26; 116; 264).

4. Apparatus as claimed in claim 3,
   **characterized in that**
   sweep gas feed means (70; 138) are disposed adjacent each of said second coupling means (36; 128) for feeding an inert sweep gas into said coupling means in the direction of said unidirectional gas flow through said coupling means.

5. Method of depositing an electrical insulator over a substrate, said method comprising the steps of:
   depositing said insulator over said substrate (30; 90; 274a) within a deposition chamber (26; 116; 264);
   transporting said substrate through a first coupling means (34; 126; 276) into said chamber (26; 116; 264);
   depositing said insulator over said substrate (30; 90; 274a) in said chamber (26; 116; 264);
   maintaining unidirectional gas flow through said first coupling means (34; 126; 276) into said chamber (26; 116; 264),
   **characterized in that**
   an inert sweep gas is feeded into said first coupling means (34; 126; 276) in the direction of said unidirectional gas flow across the top and the bottom surface of said substrate (30; 90; 274a).

6. Method as claimed in claim 5,
   **characterized in that**
   the flow rate (MF) of said unidirectional gas flow, the length (L) of said coupling means (34; 126; 278), the cross-sectional area (A) of said coupling means, the pressure (P) within said coupling means, and the diffusion coefficient (D) are related by the expression:

$$G = \sqrt{\frac{MF \times L}{D \times P \times A}}$$

where

MF is expressed in $10^5$ Pa cm$^3$/sec.

L is expressed in centimeters,

A is expressed in square centimeters,

P is expressed in $10^5$ Pa, and

D is expressed in square centimeters/sec.

and wherein said method further characterized by the step of selecting said unidirectional flow rate (MF), said coupling means length (L), said coupling means cross-sectional area (A), and said pressure (P) within said coupling means (34; 126; 276) such that G is greater than 1,8.

7. Method as claimed in claim 6,
**characterized in that**
G is between 2.00 and 4.00.

8. Method as claimed in claim 5 or 6,
**characterized in that**
process gases are fed into said deposition chamber (26; 116; 264).

9. Method as claimed in claim 8,
**characterized in that**
said process gases include helium, nitrous oxide and argon.

10. Method as claimed in one of the claims 5-9,
**characterized in that**
said step of depositing said semiconductor is performed by glow discharge deposition.

**Revendications**

1. Appareil pour le dépôt d'un isolant électrique sur un substrat (30, 90, 274a) comprenant :

une chambre de dépôt d'isolant (26 ; 116 ; 264) pour déposer ledit isolant sur ledit substrat ;

au moins une première chambre supplémentaire (24 ; 114 ; 262) adjacente à ladite chambre de dépôt d'isolant ;

un premier moyen d'accouplement (34 ; 126 ; 276) disposé entre ladite chambre de dépôt d'isolant et ladite première chambre supplémentaire afin de pouvoir être traversée par le substrat ;

un premier moyen de transport (40 ; 148 ; 272) pour transporter ledit substrat de ladite première chambre supplémentaire à ladite chambre de dépôt d'isolant ;

un premier moyen (56, 58 ; 178, 180 ; 278, 280) pour maintenir une circulation monodirectionnelle de gaz à travers ledit moyen d'accouplement de ladite première chambre supplémentaire vers ladite chambre de dépôt d'isolant ; et

un moyen d'application de gaz de balayage (68 ; 136 ; 282) monté à côté dudit premier moyen d'accouplement pour appliquer un gaz inerte de balayage dans ledit premier moyen d'accouplement dans la direction de ladite circulation monodirectionnelle de gaz,

caractérisé en ce que chacun desdits moyens d'application dudit gaz de balayage (68 ; 136 ; 282) s'étend sur toute la largeur de son moyen d'accouplement respectif (34 ; 126 ; 276) perpendiculairement à la direction de ladite circulation monodirectionnelle du gaz à travers ledit moyen d'accouplement et en ce que lesdits moyens d'application de gaz de balayage (68 ; 136 ; 282) sont placés sur les côtés opposés dudit premier moyen d'accouplement (34 ; 126 ; 276).

2. Appareil selon la revendication 1, caractérisé en ce que lesdits moyens (56, 58, 178, 180, 278, 280) pour maintenir la circulation monodirectionnelle de gaz comprennent des moyens de commande de pression afin de maintenir ladite chambre de dépôt d'isolant (26, 116, 264) sous une pression interne inférieure à la pression interne de ladite première chambre supplémentaire (24 ; 114 ; 262).

3. Appareil selon l'une des revendications 1 ou 2, caractérisé en ce qu'il comprend une seconde chambre supplémentaire (28 ; 120) adjacente à ladite chambre de dépôt d'isolant (26 ; 116 ; 264) ;

un second moyen d'accouplement (36 ; 128) disposé entre ladite chambre de dépôt d'isolant et ladite seconde chambre supplémentaire de manière à permettre audit substrat (30 ; 90 ; 274a) de le traverser ;

un second moyen de transport (42 ; 150) pour transporter ledit substrat de ladite chambre de dépôt d'isolant vers ladite seconde chambre supplémentaire ; et

un second moyen (60 ; 182) pour maintenir la circulation monodirectionnelle de gaz à travers ledit second moyen d'accouplement entre ladite seconde chambre supplémentaire (28 ; 120) et ladite chambre de dépôt d'isolant (26 ; 116 ; 264).

4. Appareil selon la revendication 3, caractérisé en ce que les moyens d'application du gaz de balayage (70 ; 138) sont disposés chacun en position adjacente auxdits seconds moyens d'accouplement (36 ; 128) afin d'appliquer un gaz inerte de balayage dans ledit moyen d'accouplement dans la direction de ladite circulation monodirectionnelle de gaz à travers ledit moyen d'accouplement.

**5.** Procédé de dépôt d'un isolant électrique sur un substrat, ledit procédé comprenant les opérations suivantes :

dépôt dudit isolant sur ledit substrat (30 ; 90 ; 274a) à l'intérieur d'une chambre de dépôt (26 ; 116 ; 264) ;

transport dudit substrat à travers un premier moyen d'accouplement (34 ; 126 ; 276) dans ladite chambre (26; 116 ; 264) ;

dépôt dudit isolant sur ledit substrat (30 ; 90 ; 274a) dans ladite chambre (26 ; 116 ; 264) ;

maintien d'une circulation monodirectionnelle de gaz à travers ledit premier moyen d'accouplement (34 ; 126 ; 276) jusque dans ladite chambre (26 ; 116 ; 264) ;

caractérisé en ce qu'un gaz de balayage inerte est appliqué dans ledit premier moyen d'accouplement (34 ; 126 ; 276) dans la direction de ladite circulation monodirectionnelle de gaz sur la surface supérieure et la surface inférieure dudit substrat (30 ; 90 ; 274a).

**6.** Procédé selon la revendication 5, caractérisé en ce que le débit (MF) de ladite circulation monodirectionnelle de gaz, la longueur (L) dudit moyen d'accouplement (34 ; 126 ; 278), la surface de la section droite (A) dudit moyen d'accouplement, la pression (P) dans ledit moyen d'accouplement, et le coefficient de diffusion (D) sont liés par l'expression :

$$G = \sqrt{\frac{MF \times L}{D \times P \times A}}$$

où :

MF est exprimé en $10^5$ Pa.cm$^3$/seconde ;
L est exprimé en cm ;
A est exprimé en cm$^2$ ;
P est exprimé $10^5$ Pa ; et
D est exprimé en cm$^2$/seconde

et dans lequel ledit procédé se caractérise encore par l'opération de sélection de ladite circulation monodirectionnelle (MF), de ladite longueur du moyen d'accouplement (L), de la surface transversale du moyen d'accouplement (A) et de ladite pression (P) dans ledit moyen d'accouplement (34 ; 126 ; 276) de manière que G soit supérieur à 1,8.

**7.** Procédé selon la revendication 6, caractérisé en ce que G est compris entre 2,00 et 4,00.

**8.** Procédé selon l'une des revendications 5 ou 6, caractérisé en ce que les gaz du processus sont appliqués dans ladite chambre de dépôt (26 ; 116 ; 264).

**9.** Procédé selon la revendication 8, caractérisé en ce que lesdits gaz de processus comprennent l'hélium, l'oxyde d'azote et l'argon.

**10.** Procédé selon l'une des revendications 5 à 9, caractérisé en ce que ladite opération de dépôt dudit semi-conducteur est effectuée au moyen d'un dépôt par décharge gazeuse.

**Patentansprüche**

**1.** Vorrichtung zum Abscheiden eines elektrischen Isolators über einem Substrat (30, 90, 274a), die folgendes aufweist:

eine Isolatorabscheidekammer (26; 116; 264) zum Abscheiden des Isolators über dem Substrat;

wenigstens eine erste Zusatzkammer (24; 114; 262) angrenzend an die Isolatorabscheidekammer;

eine erste Kopplungseinrichtung (34; 126; 276), die zwischen der Isolatorabscheidekammer und der ersten Zusatzkammer angeordnet ist, um den Durchlauf des Substrats zuzulassen;

eine erste Transporteinrichtung (40; 148; 272) zum Transportieren des Substrats von der ersten Zusatzkammer zu der Isolatorabscheidekammer;

eine erste Einrichtung (56, 58; 178, 180; 278, 280), um einen Gasstrom in eine Richtung durch die erste Kopplungseinrichtung aus der ersten Zusatzkammer in die Isolatorabscheidekammer zu unterhalten; und

Spülgaszuführeinrichtungen (68; 136; 282), die angrenzend an die erste Kopplungseinrichtung angeordnet sind, um ein inertes Spülgas in die Kopplungseinrichtung in Richtung des in eine Richtung erfolgenden Gasstroms zuzuführen,

**dadurch gekennzeichnet,**

daß jede der Spülgaszuführeinrichtungen (68; 136; 282) entlang der Gesamtbreite ihrer jeweiligen Kopplungseinrichtung (34; 126; 276) quer zu der Richtung des in eine Richtung durch die Kopplungseinrichtung gehenden Gasstroms verläuft und daß die Spülgaszuführeinrichtungen (68; 136; 282) auf entgegengesetzten Seiten der ersten Kopplungseinrichtung (34; 126; 276) angeordnet sind.

2.    Vorrichtung nach Anspruch 1,
**dadurch gekennzeichnet,**
daß die Einrichtungen (56; 58; 178; 180; 278; 280) zum Unterhalten eines in eine Richtung gehenden Gasstroms Druckregeleinrichtungen zum Halten der Isolatorabscheidekammer (26; 116; 264) auf einem niedrigeren Innendruck als dem Innendruck der ersten Zusatzkammer (24; 114; 262) aufweisen.

3.    Vorrichtung nach Anspruch 1 oder 2,
**gekennzeichnet durch**
eine zweite Zusatzkammer (28; 120) angrenzend an die Isolatorabscheidekammer (26; 116; 264);

eine zweite Kopplungseinrichtung (36; 128), die zwischen der Isolatorabscheidekammer und der zweiten Zusatzkammer angeordnet ist, um den Durchlauf des Substrats (30; 90; 274a) zuzulassen;

eine zweite Transporteinrichtung (42; 150) zum Transport des Substrats aus der Isolatorabscheidekammer zu der zweiten Zusatzkammer; und

zweite Einrichtungen (60; 182) zum Unterhalten eines Gasstroms in eine Richtung durch die zweite Kopplungseinrichtung aus der zweiten Zusatzkammer (28; 120) in die Isolatorabscheidekammer (26; 116; 264).

4.    Vorrichtung nach Anspruch 3,
**dadurch gekennzeichnet,**
daß Spülgaszuführeinrichtungen (70; 138) angrenzend an jede der Kopplungseinrichtungen (36; 128) angeordnet sind, um in die Kopplungseinrichtungen ein inertes Spülgas in Richtung des in eine Richtung gehenden Gasstroms durch die Kopplungseinrichtung zuzuführen.

5.    Verfahren zum Abscheiden eines elektrischen Isolators über einem Substrat, wobei das Verfahren die folgenden Schritte aufweist:

Abscheiden des Isolators über dem Substrat (30; 90; 274a) innerhalb einer Abscheidekammer (26; 116; 264);

Transportieren des Substrats durch eine erste Kopplungseinrichtung (34; 126; 276) in die Kammer (26; 116; 264);

Abscheiden des Isolators über dem Substrat (30; 90; 274a) in dieser Kammer (26; 116; 264);

Unterhalten eines in eine Richtung gehenden Gasstroms durch die erste Kopplungseinrichtung (34; 126; 276) in die Kammer (26; 116; 264),
**dadurch gekennzeichnet,**
daß ein inertes Spülgas in die erste Kopplungseinrichtung (34; 126; 276) in Richtung des in eine Richtung gehenden Gasstroms über die Oberseite und die Unterseite des Substrats (30; 90; 274a) zugeführt wird.

6.    Verfahren nach Anspruch 5,
**dadurch gekennzeichnet,**
daß die Durchflußmenge (MF) des in eine Richtung gehenden Gasstroms, die Länge (L) der Kopplungseinrichtung (34; 126; 278), die Querschnittsfläche (A) der Kopplungseinrichtung, der Druck (P) in der Kopplungseinrichtung und der Diffusionskoeffizient (D) durch den folgenden Ausdruck in Beziehung zueinander stehen:

$$G = \sqrt{\frac{MF \times L}{D \times P \times A}}$$

wobei
MF in 10 Pa cm$^3$/s ausgedrückt ist,
L in cm ausgedrückt ist,
A in cm$^2$ ausgedrückt ist,
P in 10$^5$ Pa ausgedrückt ist und
D in cm$^2$/s ausgedrückt ist,
und wobei das Verfahren ferner gekennzeichnet ist durch den folgenden Schritt: Auswählen der Ein-Richtungs-Durchflußmenge (MF), der Kopplungseinrichtungs-Länge (L), der Kopplungseinrichtungs-Querschnittsfläche (A) und des Drucks (P) im Inneren der Kopplungseinrichtung (34; 126; 276) derart, daß G größer als 1,8 ist.

7.    Verfahren nach Anspruch 6,
**dadurch gekennzeichnet,**
daß G zwischen 2,00 und 4,00 liegt.

8.    Verfahren nach Anspruch 5 oder 6,
**dadurch gekennzeichnet,**
daß Prozeßgase in die Abscheidekammer (26; 116; 264) eingeleitet werden.

9.    Verfahren nach Anspruch 8,
**dadurch gekennzeichnet,**
daß die Prozeßgase Helium, Stickstoff(I)-oxid und Argon umfassen.

10.   Verfahren nach einem der Ansprüche 5-9,
**dadurch gekennzeichnet,**
daß der Schritt des Abscheidens des Halbleiters mittels Glimmentladungsabscheidung durchgeführt wird.

FIG. 1

FIG. 2

FIG. 3

FIG. 4

FIG. 5

FIG. 6

**FIG. 7**

EP 0 210 578 B1

FIG. 8

FIG. 9

FIG. 10

FIG. 11A

FIG. 11B

FIG. 12

FIG. 13

EP 0 210 578 B1